# DEMANDE DE BREVET EUROPEEN

(11) **EP 2 506 290 A1**
(43) Date de publication de la demande: **03.10.2012**
(21) Numéro de dépôt: 12162349.0
(22) Date de dépôt: 30.03.2012
(51) Int. Cl.: H01L 21/205, H01L 29/08, H01L 21/02

(54) **Procédé de formation d'une couche épitaxiée, en particulier sur des régions de source et de drain de transistor à appauvrissement total**

(30) Priorité: 01.04.2011 FR 1152821
(71) Demandeur: STMicroelectronics (Crolles 2) SAS, 38920 Crolles (FR); STmicroelectronics SA, 92120 Montrouge (FR)
(72) Inventeur: Dutartre, Didier, 38240 MEYLAN (FR); Campidelli, Yves, 38580 Le Moutaret (FR); Pellissier-Tanon, Denis, 38000 GRENOBLE (FR); Loubet, Nicolas, GUILDERLAND - New York, 12084 (US)
(74) Mandataire: Casalonga, Axel

(57) **Abrégé**

Procédé comprenant :
(a) une épitaxie d'une couche d'un matériau semi-conducteur sur une structure semi-conductrice monocristalline (S,D) et sur une structure semi-conductrice polycristalline (G),
(b) une gravure de ladite couche épitaxiée de manière à conserver une épaisseur non nulle dudit matériau sur la structure monocristalline (S,D) et une épaisseur nulle sur la structure polycristalline (G),
(c) au moins une répétition de l'étape (a) avec le même matériau ou un matériau différent, lesdites structures monocristallines (S,D) et polycristallines (G) étant respectivement celles obtenues à l'issue de l'étape (b) précédente, et au moins une répétition de l'étape (b), jusqu'à obtenir une épaisseur désirée (EE) pour l'empilement de couches épitaxiées sur ladite structure monocristalline (S,D).

## Description

L'invention concerne la microélectronique, et notamment la formation de couches épitaxiées de matériau semi-conducteur, en particulier des couches épitaxiées formant des régions de source ou de drain de transistors, tels que des transistors à appauvrissement total réalisés sur du silicium sur isolant (SOI : Silicon On Insulator).

Des étapes d'épitaxies peuvent être mises en oeuvre afin de contrôler les propriétés électriques des régions de source et de drain de transistors à grilles isolées. On peut notamment contrôler les quantités de dopants présents au sein de ces régions monocristallines en introduisant des dopants dans les couches de silicium épitaxiées. On peut également introduire des atomes de germanium ou de carbone afin de modifier les contraintes mécaniques au sein des couches épitaxiées et augmenter la mobilité des porteurs de charges dans les régions de source et de drain.

En outre, les grilles des transistors comprennent de manière classique au moins une couche de silicium polycristallin, éventuellement disposée au dessus d'une couche métallique.

Lors de la formation des régions de source et de drain par épitaxie, une couche épitaxiée peut également apparaître sur les grilles des transistors comportant du silicium polycristallin. L'épitaxie sur la grille est en outre favorisée par la structure polycristalline, qui comprend des grains de silicium monocristallin et des interfaces entre ces grains semblables à un matériau amorphe. Il peut alors résulter la formation d'une protubérance en forme de champignon sur la grille dont l'épaisseur peut être supérieure à l'épaisseur épitaxiée sur les régions de source et de drain.

Lors de la formation de transistors dans des technologies avancées, par exemple pour des longueurs de grille inférieures à 32 nanomètres, la présence de cette protubérance épitaxiée sur les grilles des transistors peut provoquer l'apparition de courts-circuits entre des grilles voisines, ou encore entre les plots de contact source/drain et les grilles des transistors.

Par ailleurs, la fabrication des circuits intégrés comportant des transistors à appauvrissement total sur un substrat de silicium sur isolant (SOI), peut comprendre une épitaxie de matériau semi-conducteur destinée à épaissir les régions de source et de drain. Cet épaississement peut notamment faciliter la formation d'un siliciure de métal sur lesdites régions en vue d'une prise de contact. Les régions de source et de drain d'un transistor à appauvrissement total ont, avant épitaxie, une épaisseur de l'ordre de deux ou trois nanomètres. Afin d'obtenir une épaisseur de silicium permettant la formation des contacts, une épitaxie de l'ordre de la vingtaine de nanomètre peut être mise en oeuvre. Une telle épitaxie peut donc provoquer l'apparition d'une protubérance épitaxiée sensiblement épaisse sur les grilles des transistors à appauvrissement total, avec les inconvénients mentionnés ci-avant.

Il a été proposé d'utiliser un masque dur au dessus de la grille du transistor de manière à empêcher la formation de la protubérance de silicium.

Cela étant, l'utilisation d'un masque dur est onéreuse et complexe à mettre en oeuvre.

Selon un mode de mise en oeuvre, il est proposé d'améliorer l'épitaxie de matériau semi-conducteur de manière à obtenir une épaisseur désirée de matériau épitaxié sur une structure monocrystalline, et une épaisseur nulle sur une structure polycristalline.

Selon un aspect, il est proposé un procédé comprenant :
(a) une épitaxie d'une couche d'un matériau semi-conducteur sur une structure semi-conductrice monocristalline et sur une structure semi-conductrice polycristalline,
(b) une gravure de ladite couche épitaxiée de manière à conserver une épaisseur non nulle dudit matériau sur la structure monocrystalline et une épaisseur nulle sur la structure polycristalline
(c) au moins une répétition de l'étape (a) avec le même matériau ou un matériau différent, lesdites structures monocristallines et polycristallines étant respectivement celles obtenues à l'issue de l'étape (b) précédente, et au moins une répétition de l'étape (b), jusqu'à obtenir une épaisseur désirée pour l'empilement de couches épitaxiées sur ladite structure monocristalline.

La cinétique des étapes d'épitaxie, ainsi que la cinétique des étapes de gravure, dépend de la structure du matériau à graver. Plus précisément, une épitaxie sur un matériau polycristallin est plus rapide que sur un matériau monocristallin, et une gravure d'un matériau polycristallin, éventuellement épitaxié, est plus rapide qu'une gravure d'un matériau monocristallin.

A titre d'exemple, lors d'une épitaxie d'une couche de silicium sur du silicium monocristallin, par exemple un drain ou une source d'un transistor, et sur du silicium polycristallin, par exemple une grille d'un transistor, il est possible d'obtenir des cinétiques de croissance de l'ordre de cinq nanomètres par minute sur la structure monocristalline, et de 10 nanomètres par minute sur la structure polycristalline. Lors d'une étape de gravure, il est possible d'obtenir une cinétique de gravure de l'ordre de 1 nanomètre par minute sur la structure monocristalline, et de 10 nanomètres par minute sur la structure polycristalline.

Ainsi, en effectuant une répétition d'épitaxies et de gravures sur des structures monocristallines et polycristallines, on peut obtenir une épaisseur contrôlée de matériau épitaxié sur la structure monocristalline et une épaisseur nulle sur la structure polycristalline.

Avantageusement, le procédé comprend en outre une épitaxie initiale d'un matériau semi-conducteur initial sur une structure monocristalline initiale et une structure polycristalline initiale, par exemple des régions initialement fines de source/drain au sein d'un substrat SOI et des régions de grilles de transistor à appauvrissement total, de façon à obtenir lesdites structures monocristallines et polycristallines sur lesquelles vont être mises en oeuvre la ou les boucles épitaxie-gravure ; et ladite épitaxie initiale est mise en oeuvre à une température plus basse que l'épitaxie de l'étape (a).

L'épitaxie initiale permet notamment de solidifier et de préparer la surface de la structure monocristalline.

La mise en oeuvre de cette épitaxie initiale à une température plus basse que l'épitaxie de l'étape (a) s'applique particulièrement au couches de silicium les plus fines, par exemple les drains et les sources d'un transistor à appauvrissement total.

On peut également mettre en oeuvre l'épitaxie initiale au cours de phases de rampe et de stabilisation en température, et éventuellement dès le chargement des matériaux dans un réacteur d'épitaxie.

Ces couches fines, par exemple d'une épaisseur inférieure à dix nanomètres, sont instables lors d'une élévation de température.

Une épitaxie initiale sous une température permettant de conserver la stabilité de ces structures monocristallines fines permet d'obtenir une faible augmentation d'épaisseur qui peut être suffisante pour conférer aux structures monocristalline la stabilité nécessaire pour les étapes (a) et (b).

Par ailleurs, les étapes (a) et (b) sont mises en oeuvre à des températures plus élevées afin d'obtenir des cinétiques plus élevées.

Les couches fines peuvent être endommagées par d'éventuelles étapes de gravure antérieures. Ainsi, les couches monocristallines peuvent être partiellement amorphes si la structure cristalline a été endommagée.

La température de mise en oeuvre de l'épitaxie initiale peut permettre une recristallisation des structures monocristallines.

L'homme du métier saura choisir les températures de l'épitaxie initiale afin de ne pas endommager la structure monocristalline, de permettre une épitaxie solidifiant la structure monocristalline, et de permettre une recristallisation.

Avantageusement, le procédé comprend en outre, postérieurement à l'épitaxie initiale, une gravure initiale de manière à conserver une épaisseur non nulle dudit matériau sur la structure monocristalline initiale et une épaisseur nulle sur la structure polycristalline initiale, ladite gravure initiale étant mise en oeuvre à une température plus basse que la gravure de l'étape (b).

Le procédé peut comprendre une étape finale d'épitaxie d'un matériau semi-conducteur sur la structure monocristalline et la structure polycristalline obtenues après la dernière étape (b).

On obtient ainsi une finition de la surface du matériau épitaxié.

Avantageusement, les étapes (a) et (b) sont mises en oeuvre dans un même réacteur d'épitaxie à une température constante.

Les étapes (a) et (b) peuvent également être mises en oeuvre dans un même réacteur d'épitaxie sous une pression constante.

L'utilisation d'un même réacteur sous une pression constante et/ou une température constante permet de simplifier le contrôle des étapes d'épitaxie et de gravure.

L'utilisation d'un même réacteur permet également d'augmenter la productivité du procédé.

En outre, on obtient une simplification du contrôle de la cinétique d'épitaxie et de gravure.

D'autres avantages et caractéristiques de l'invention apparaîtront à l'étude de la description détaillée de modes de mise en oeuvre, pris à titre d'exemples non limitatifs et illustrés par les dessins annexés sur lesquels :

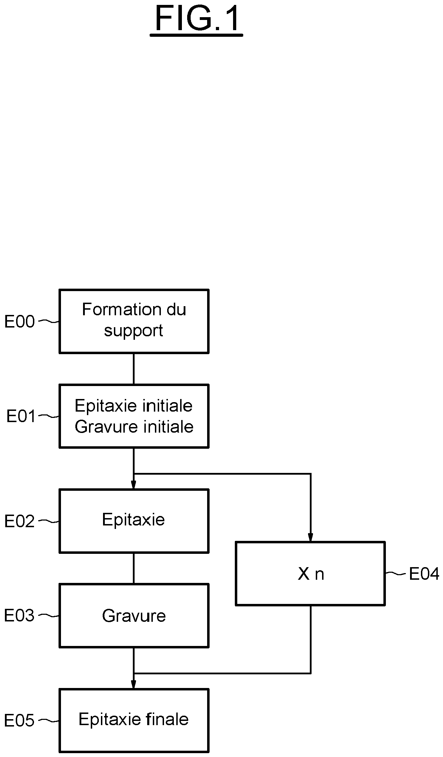

- les figures 1, 2 et 3 illustrent un mode de mise en oeuvre selon l'invention.

La figure 1 décrit schématiquement les étapes d'un procédé selon un aspect de l'invention.

Lors d'une première étape E00, on forme un support sur lequel on désire former une couche épitaxiée. Cette étape E00 comprend éventuellement la formation d'un substrat semi-conducteur ou d'un substrat de silicium sur isolant (SOI), ainsi que la formation d'au moins une structure monocristalline initiale et d'une structure polycristalline initiale. La structure monocristalline initiale peut être contenue dans le support, par exemple dans le substrat SOI. La structure polycristalline peut être une région de grille isolée réalisée sur le substrat au dessus d'une partie de structure monocristalline initiale.

Bien entendu, la formation du support peut comprendre la formation d'autres composants dans des matériaux semi-conducteurs différents du silicium.

Une étape E01 d'épitaxie initiale d'un matériau initial et de gravure initiale est ensuite mise en oeuvre de façon optionnelle.

L'étape E01 s'applique particulièrement aux structures les plus fines, par exemple d'une épaisseur inférieure à dix nanomètres, car cette étape permet de solidifier la structure monocristalline initiale, et elle permet également de recristalliser cette structure.

A titre d'exemple, on pourra, lors de cette étape initiale, épitaxier une couche de silicium, sous une température de l'ordre de 600°C, en utilisant un mélange de gaz comprenant du dichlorosilane (SiH₂Cl₂) et d'acide chlorhydrique (HCl).

Cette étape E01 comprend également une gravure initiale, de manière à conserver une épaisseur non nulle dudit matériau initial épitaxié sur la structure monocristalline initiale et une épaisseur nulle sur la structure polycristalline initiale.

Cette gravure initiale peut comprendre une gravure chimique au moyen d'un gaz d'acide chlorhydrique (HCl). La vitesse de gravure est en outre contrôlée de manière à conserver une épaisseur non nulle dudit matériau initial sur la structure monocristalline initiale.

La température de cette étape initiale E01 peut être choisie de manière à conserver la stabilité de la structure monocristalline initiale tout en permettant une recristallisation de cette structure.

A titre d'exemple, lors d'une épitaxie de silicium, on pourra utiliser une température de l'ordre de 600°C, et pour une épitaxie d'un alliage silicium-germanium comprenant au moins 30% de germanium, on pourra utiliser une température de l'ordre de 550°C.

Par ailleurs, la durée des étapes d'épitaxie initiale et de gravure initiale peut être par exemple de l'ordre de la minute.

L'étape E01 permet donc d'obtenir une structure monocristalline stable et robuste, capable de conserver ses propriétés sous des températures plus élevées.

La structure polycristalline initiale n'est pas modifiée par l'étape E01 et forme une structure polycristalline.

C'est sur ces structures monocristalline et polycristalline que l'on va maintenant appliquer des cycles d'épitaxie et de gravure.

Plus précisément, une épitaxie E02 d'une couche d'un matériau semi-conducteur sur la structure monocristalline et sur la structure polycristalline est ensuite mise en oeuvre.

Cette étape est mise en oeuvre à une température plus élevée que la température de l'étape E01. On peut ainsi obtenir une vitesse de croissance suffisamment élevée.

On pourra par exemple former une couche de silicium, sous une température de l'ordre de 700°C à 750°C, en utilisant un mélange de gaz comprenant du dichlorosilane (SiH₂Cl₂) et d'acide chlorhydrique (HCl).

Pour l'épitaxie d'une couche d'un alliage de silicium-germanium on utilisera par exemple une température de l'ordre de 600°C à 650°C.

On peut également choisir le matériau semi-conducteur à épitaxier dans le groupe formé par le silicium, le germanium, un alliage silicium-germanium, un alliage silicium-carbone et un alliage silicium-germanium-carbone.

L'homme du métier saura ajuster les températures de cette étape E02 en fonction des couches des matériaux à former, ainsi que la durée de cette étape, par exemple de l'ordre de la minute, en fonction de l'épaisseur à épitaxier.

A titre d'exemple, l'étape E02 peut être mise en oeuvre sous une pression de l'ordre de vingt torrs, contenant par exemple du dichlorosilane (SiH₂Cl₂) sous une pression partielle de cinquante millitorrs et de l'acide chlorhydrique (HCl) sous une pression partielle de trente millitorrs.

La couche de matériau semi-conducteur épitaxiée sur la structure monocristalline est plus fine que la couche de matériau épitaxiée sur la structure polycristalline.

En effet, l'épitaxie est favorisée par la structure polycristalline qui comprend des grains et dont l'interface entre ces grains est presque amorphe.

A titre d'exemple, on pourra obtenir une vitesse de formation de la couche de l'ordre de cinq nanomètres par minute sur la structure monocristalline contre dix nanomètres par minute sur la structure polycristalline.

Une étape de gravure est ensuite mise en oeuvre (étape E03).

Cette étape comprend une gravure chimique au moyen d'un gaz comprenant par exemple de l'acide chlorhydrique (HCl).

La structure polycristalline étant gravée plus rapidement que la structure monocristalline, cette étape permet de conserver une épaisseur non nulle de matériau semi-conducteur sur la structure monocristalline, et une épaisseur nulle de matériau formé sur la structure polycristalline.

A titre d'exemple, on pourra obtenir une vitesse de gravure de la couche de l'ordre de 1 nanomètre par minute sur la structure monocristalline contre 10 nanomètre par minute sur la structure polycristalline.

L'étape E03 peut être mise en oeuvre dans un réacteur sous une pression de l'ordre de vingt torrs, contenant par exemple de l'acide chlorhydrique sous une pression partielle de 2,5 torrs.

Les étapes E02 et E03 sont ensuite répétées n fois (étape E04), le nombre n étant choisi en fonction de l'épaisseur désirée pour l'empilement de couches épitaxiées sur la structure monocristalline.

On pourra notamment changer la composition du matériau épitaxié lors de l'étape E02 lors de certaines au moins de ces répétitions.

Par exemple, il est possible d'introduire des dopants dans le matériau semi-conducteur épitaxié, et de contrôler ainsi le profil de dopage à travers la superposition des couches épitaxiées.

A titre d'exemple, lors de la formation d'une couche de silicium sur la source et le drain d'un transistor à appauvrissement total, on peut obtenir après cinq répétitions des étapes E02 et E03 une épaisseur de l'ordre de vingt nanomètres sur la structure monocristalline sans formation de protubérance sur la structure polycristalline.

Lors des répétitions des étapes E02 et E03, différents réacteurs d'épitaxie et de gravure peuvent être utilisées, et les températures et les pressions des différents gaz peuvent être adaptées de manière à obtenir les épaisseurs voulues.

Il est également possible d'utiliser un même réacteur lors des étapes E02 et E03, ainsi qu'une température constante et une pression constante.

Une fois l'épaisseur désirée de l'empilement de couches épitaxiés atteinte, une épitaxie finale (E05) peut être mise en oeuvre.

Cette étape permet notamment d'améliorer l'état de la surface de la dernière couche épitaxiée, éventuellement endommagée par la dernière étape de gravure E03.

L'épitaxie finale peut être d'une durée courte, par exemple la moitié de la durée d'une étape d'épitaxie E02. Ainsi, la quantité de matériau formé sur la structure polycristalline est négligeable.

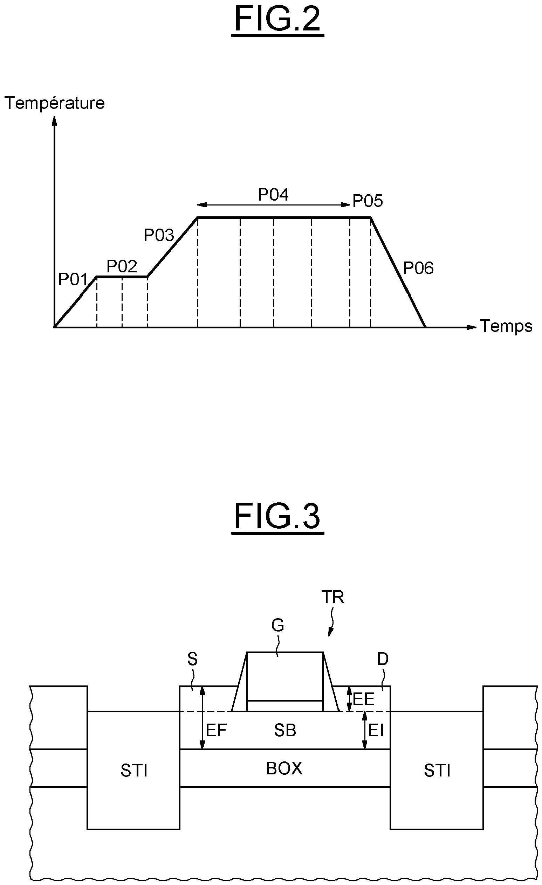

Sur la figure 2, on a représenté graphiquement l'évolution de la température au cours d'un procédé selon un aspect de l'invention.

Plus précisément, on a représenté l'évolution de la température au cours d'un procédé dans lequel les étapes d'épitaxie E02 et de gravure E03 sont réalisées dans un même réacteur sous une température et une pression constante.

Lors d'une première phase P01, les structures polycristallines et monocristallines subissent une première élévation de température, de manière à mettre en oeuvre l'étape E01 d'épitaxie initiale et de gravure initiale (phase P02). On peut par exemple atteindre une température de l'ordre de 600°C pour une formation de silicium.

La phase P02 comprend les étapes d'épitaxie initiale et de gravure initiale, effectuées pendant des durées par exemple inférieures à la minute.

Une deuxième rampe de température (phase P03) permet d'atteindre une température suffisamment élevée pour les étapes d'épitaxie E02 et de gravure E03. On peut par exemple atteindre une température de l'ordre de 700°C à 750°C pour une formation de silicium.

Les étapes d'épitaxie initiale et de gravure initiale peuvent également être effectuées durant les phases P01, P02 et P03, c'est-à-dire durant toutes les phases de rampe en température et de stabilisation en température.

Pendant la phase P04, une boucle E04 est mise en oeuvre comprenant deux épitaxie E02 et deux gravure E03.

La température et la pression restent toutes les deux constantes pendant cette phase P04.

En outre, pour une vitesse de croissance par épitaxie de cinq nanomètres par minute sur une structure monocristalline contre dix nanomètres par minute sur une structure polycristalline, et une vitesse de gravure de un nanomètre par minute sur la structure monocristalline contre 10 nanomètres par minute sur la structure polycristalline, on obtient une épaisseur finale de l'ordre de 4 nanomètres sur la structure monocrystalline et une épaisseur nulle sur la structure polycristalline après chaque cycle comprenant une minute de dépôt.

La phase P05 comprend l'épitaxie finale E05, mise en oeuvre à la même température que les étapes de la phase P04.

Une phase P06 comprenant une rampe descendante de température est enfin mise en oeuvre de manière à pouvoir sortir les structures du réacteur.

L'invention s'applique particulièrement bien à la réalisation de transistors à appauvrissement total.

Sur la figure 5, on a représenté un transistor à appauvrissement total TR obtenu par exemple après l'étape d'épitaxie finale E05.

L'utilisation d'une étape d'épitaxie initiale est particulièrement avantageuse pour ce type de transistor dont les épaisseurs initiales EI des sources S et drains D monocristallins situés dans un substrat SB sur isolant BOX sont de l'ordre de deux ou trois nanomètres.

On obtient ainsi une épaisseur épitaxiée EE formant une région d'épaisseur totale EF permettant la réalisation de contacts sur ces structures monocristallines.

En outre, on obtient une grille G polycristalline inchangée (sans protubérance), et ce sans utiliser de masque dur.

On notera que les étapes d'épitaxie E02 et de gravure E03 permettent également de ne pas former de matériau semi-conducteur épitaxié sur les tranchées d'isolations peu profondes STI.

## Revendications

1. Procédé comprenant :
(a) une épitaxie d'une couche d'un matériau semi-conducteur sur une structure semi-conductrice monocristalline (S,D) et sur une structure semi-conductrice polycristalline (G),
(b) une gravure de ladite couche épitaxiée de manière à conserver une épaisseur non nulle dudit matériau sur la structure monocristalline (S,D) et une épaisseur nulle sur la structure polycristalline (G),
(c) au moins une répétition de l'étape (a) avec le même matériau ou un matériau différent, lesdites structures monocristallines (S,D) et polycristallines (G) étant respectivement celles obtenues à l'issue de l'étape (b) précédente, et au moins une répétition de l'étape (b), jusqu'à obtenir une épaisseur désirée (EE) pour l'empilement de couches épitaxiées sur ladite structure monocristalline (S,D).

2. Procédé selon la revendication 1, comprenant en outre une épitaxie initiale d'un matériau semi-conducteur initial sur une structure monocristalline initiale et une structure polycristalline initiale de façon à obtenir lesdites structures monocristallines (S,D) et polycristallines (G), ladite épitaxie initiale étant mise en oeuvre à une température plus basse que l'épitaxie de l'étape (a).

3. Procédé selon la revendication 2, comprenant en outre, postérieurement à l'épitaxie initiale, une gravure initiale de manière à conserver une épaisseur non nulle dudit matériau sur la structure monocristalline initiale et une épaisseur nulle sur la structure polycristalline initiale, ladite gravure initiale étant mise en oeuvre à une température plus basse que la gravure de l'étape (b).

4. Procédé selon l'une quelconque des revendications précédentes, comprenant une étape finale d'épitaxie d'un matériau semi-conducteur sur la structure monocristalline (S,D) et la structure polycristalline (G) obtenues après la dernière étape (b).

5. Procédé selon l'une quelconque des revendications précédentes, dans lequel les étapes (a) et (b) sont mises en oeuvre dans un même réacteur d'épitaxie à une température constante.

6. Procédé selon l'une quelconque des revendications précédentes, dans lequel les étapes (a) et (b) sont mises en oeuvre dans un même réacteur d'épitaxie sous une pression constante.

7. Procédé selon l'une quelconque des revendications précédentes, dans lequel dans l'étape (a) la composition du matériau semi-conducteur diffère lors d'au moins deux répétitions de cette étape.

8. Procédé selon l'une quelconque des revendications précédentes, dans lequel le matériau semi-conducteur est choisi dans le groupe formé par le silicium, le germanium, un alliage silicium-germanium, un alliage silicium-carbone et un alliage silicium-germanium-carbone.

9. Procédé selon l'une quelconque des revendications précédentes, dans lequel ladite structure monocristalline (S,D) comprend des régions de sources et de drains de transistors (TR) et ladite structure polycristalline (G) comprend des régions de grilles de transistors.

10. Procédé selon la revendication 9, dans lequel les transistors (TR) sont des transistors à appauvrissement total.
